# EUROPEAN PATENT SPECIFICATION

(11) **EP 0 603 932 B1**
(45) Date of publication and mention of the grant of the patent: **08.04.1998**
(21) Application number: 93203443.2
(22) Date of filing: 09.12.1993
(51) Int. Cl.: H03M 13/00

(54) **Method and apparatus for implementing a quasi-product code with different degrees of protection against errors**
Verfahren und Vorrichtung zur Realisierung eines Quasiproduktkodes mit verschiedenen Fehlerschutzstufen
Méthode et dispositif de mise en oeuvre d'un code quasi-produit avec différents degrés de protection contre les erreurs

(30) Priority: 14.12.1992 EP 92203891
(43) Date of publication of application: 29.06.1994
(73) Proprietor: Philips Electronics N.V., 5621 BA Eindhoven (NL)
(72) Inventor: Tolhuizen, Ludovicus Marinus Gerardus Maria, NL-5656 AA Eindhoven (NL)
(74) Representative: Peters, Rudolf Johannes

(56) References cited:
- EP-A- 0 471 085
- TRANSACTIONS OF THE INSTITUTE OF ELECTRONICS, INFORMATION AND COMMUNICATION ENGINEERS OF JAPAN, vol.E74, no.3, March 1991, TOKYO JP pages 512 - 519 T. NISHIJIMA ET AL. 'On Asymptotic Distance Ratios for the Constructive Concatenated Codes with Unequal Error Protection'
- TRANSACTIONS OF THE INSTITUTE OF ELECTRONICS, INFORMATION AND COMMUNICATION ENGINEERS E, JULY 1990, JAPAN, VOL. E73, NR. 7, PAGES 1176 - 1180, ISSN 0913-574X S. HIRASAWA ET AL 'Coding and decoding schemes with unequal symbol reliability'
- IEEE TRANSACTIONS ON INFORMATION THEORY., vol.IT-3, no.4, October 1967, NEW YORK US pages 600 - 607 B. MASNICK ET AL. 'On linear unequal error protection codes'

## Description

### FIELD OF THE INVENTION

The invention relates to a method for encoding digital data with at least two different degrees of error protection, said method comprising distributing uniform-size user elements of said data over an array of at least two dimensions, supplementing according to at least one of said dimensions said user elements with first redundant elements of said uniform size of a first linear coding, and supplementing according to at least a second one of said dimensions said user elements and first redundant elements with second redundant elements of said uniform size of a second linear coding.

Such a method has been described in US-A 4,680,764, which shows the error protection format of the so-called third layer in Compact Disc Read Only Memory, or CD-ROM for short. The code is a pseudo-product code in that the second redundant elements are not protected by the first error protective code. This means that the degree of error protection of the second redundant elements is less than the degree of error protection for either the user elements or the first redundant elements. It has been found that often certain user elements have a higher importance than certain others, in that any interference on the former would cause relatively more damage than on the latter. Examples are that computer data is more vulnerable than audio, because errors in audio can be concealed, such as through interpolation that is useless for computer data. Also, audio is more vulnerable than video, because the human eye is more forgiving than the human ear. Also among information of a single category certain elements could warrant extra protective measures above those taken for other user elements. An example of elements justifying such extra protective measures would for example be intensity scaling factors of a video picture. The article titled "on asymptotic distance ratios for the constructive concatenated cods with unequal error protection" published in the Transactions of the Institute of Electronics, Information, and Comm. Engineers, vol E74, N°3, pages 512-519 describes error-correction concatenated cods providing different degrees of error protection. The present invention therefore, carries the principle of different degrees of error protection to the user elements, and as such scrupulously applies an input-output analysis of using greater redundancy versus realizing enhanced protection.

### SUMMARY TO THE INVENTION

Now, amongst other things, it is an object of the present invention to provide a method that allows for straightforward encoding at respective different levels of error protection, and while allowing easy selection of the user elements that would deserve the lower, or the higher degree of error protection, respectively. Now according to one of its aspects, the invention is characterized in that said first linear coding for at least one first line of user elements realizes a higher degree of error protection than for at least one second line of user elements in that the former is realized as a first code that has more of said first redundant elements than the latter that is realized as a second code. A particular advantage of the array-wise organization is its simplicity, in that various codings may be organized as a series of parallel-occurring multi-symbol code words, wherein the symbols may have one bit each, or preferably have an organization that is suitable for data processing, such as based on 8-bit bytes or any other suitable format.

Advantageously, all code words of said first coding have a first uniform size and all code words of said second coding have a second uniform size. Especially for intermediate storage of received data in a memory, and also for easy control of interleaving of the symbols when transported along a physical medium channel or by broadcast, this is a positive aspect. Alternatively, the extra redundancy could in whole or in part lead to larger code words.

Advantageously, said higher degree of error protection is realized through a greater minimum distance. This means that the error protection, as measured in the number of erroneous user elements that can be corrected and/or detected is higher for the first code. Another solution is that the measure provides an increased protection for certain error types, such as burst errors, that may however, not be expressed as a greater minimum distance. An example of codes offering a high degree of error protection against burst codes are so-called Fire-codes.

Advantageously, said first linear coding is also arranged to protect said second redundant elements. This provides a particularly straightforward code organization.

Advantageously, said first code is a subcode of said second code. This renders the encoding and decoding simple, in that much of the hardware used for one code is reusable for the other.

The invention also relates to a method for decoding user data that have been encoded according to the foregoing. By itself, decoding of multisymbol code words is a well established art. Given a particular degree of error protection through an associated number of redundant elements, various strategies are possible, such strategies also depending on the code actually used. Advantageously, all code words of said second coding relating to said array are decoded first before enabling decoding of any code word of said first code relating to said array. This is a very straightforward way of decoding. In particular, if a second code word would contain a burst error, its decoding usually fails, but such failure could be translated to an erasure flag for the appropriate first code word to alleviate its decoding burden. By itself, error decoding technology has developed a host of decoding stratagems, that could be used in any feasible measure or combination.

The invention also relates to an encoder for implementing the method, and to a decoder for implementing the method. Further advantageous aspects are recited in dependent Claims.

### BRIEF DESCRIPTION OF THE DRAWINGS

Further aspects and advantages of the invention will become apparent through the disclosure of preferred embodiments that are also shown in and by the appended Figures, and in particular:
Figure 1 shows a first format of the error protective codings;
Figure 2 is a block diagram of an encoding and/or decoding device according to the invention.

### DESCRIPTION OF THE PREFERRED EMBODIMENTS

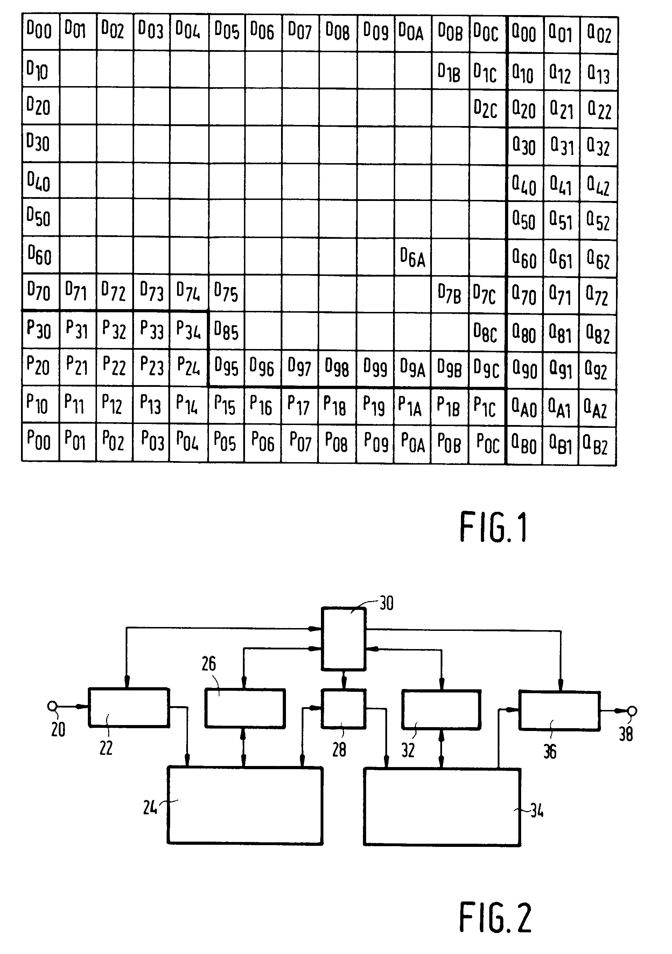

Figure 1 shows a first format of the error protective codings. The data symbols such as bytes are arranged according to rows and columns. The upper row has 13 data symbols D₀₀..D_{0C}, and similarly for the next seven rows. In the next two rows, there are only eight data symbols. Next, there are four parity symbols P₃₀...P₀₀ in the first column, and likewise for the next four columns. The next eight columns have only two parity symbols each. An advantageous realisation now is that each column is encoded according to a Reed-Solomon code, wherein the code with the four parity symbols is a subcode of the two-parity symbol code. For brevity, other codes such as binary BCH codes are not considered in this example. Now, generating a subcode occurs through introduction of extra zeroes into the generator polynomial. This means that the generator polynomial with the lesser number of zeroes is a factor of the polynomial with the greater number of zeroes. The subcode, in consequence has a larger distance, and fewer code words. Now the use of a subcode with respect to the earlier columns allows to use hardware that is present for those earlier columns also for the later columns, for example in that a part of the syndrome symbols for the earlier columns can be calculated by exactly the same expressions as those for the later columns. Of course, the hardware part incorporating the strategy would generally, but not even necessarily, different. Now, the earlier columns have a symbol-wise minimum distance of **five**, which would allow for two-symbol correction. The later columns have a symbol-wise minimum distance of **three**, which would allow for one-symbol correction. Other usages of the protection offered by the number of parity symbols actually present are well-known in the art. The codes used need not at all be Reed-Solomon codes, but are preferably linear, which means that the sum of two correct code words again produces a correct code word. The term -correct code word- is by itself redundant in that standard art usage is -code word-; the principle of error correction is then that any non-code word should be associated to a particular code word. The codes are also preferably systematic on the level of the user elements or symbols. It has been known in the art that linear codes can be made systematic through symbol permutation. On the other hand symbol permutation on systematic code keeps as result a linear code. Now, the use of the exemplary Reed-Solomon codes especially in case of the product-like codes of the envisaged format, greatly facilitates the decoding. Moreover, also the degree of error protection is easily ascertained for these codes. As told earlier, the codes need not be maximum distance separable, as various other classes of code would also produce an appropriate degree of protection.

As shown in the Figure, also each row has three parity symbols, that in the case of a Reed-Solomon code would give a minimum distance of **four** and, therefore, would allow for a symbol-wise single error correction, double error detection. A first solution is that the three parity symbols cover all symbols on their own row. This leads to a quasi-product code, in that symbols Q_{A0}, Q_{A1}, Q_{A2}, Q_{B0}, Q_{B1}, Q_{B2} would constitute parity symbols of both their respective rows and of their respective columns, thereby also giving the distance-four error protection to the rows of Q-parity symbols. A second solution corresponds to that referred to with respect to CD-ROM, in that the code words associated to the Q-parity symbols jump through the respective rows. For example, such code word could be constituted by the following symbols: Q₅₂, Q₄₁, Q₃₂, D_{2C}, D_{1B}, D_{0A}, P₀₉, P₁₈, D₉₇, D₈₆,....D₂₀. In this situation, there is no protection of the Q-parity symbols by the vertical codes.

Through judicious selection of the generator matrices of the various codes, the codes of the first five columns can be subcodes of the code of the columns 6-13. This means that any correct code word of the former columns would constitute a correct code word of the latter columns, but not the other way round. Naturally, this would mean hardware savings for encoder, and often , also for decoder. Furthermore, also the generator and parity check matrices of the row (or, if applicable, diagonal) code words could to a large degree correspond, leading to further hardware savings. The foregoing related to a two-dimensional array, only one dimension thereof having two different degrees of error protection by the first and second codes, respectively. Of course, the layout of the array, even with unchanged parameters can be varied according to need, for example through swapping of columns, other dimensions, etcetera. The idea of the invention can be expanded. First, the array can have more than two dimensions, for example three. Second, there may more than two different degrees of error protection shown along the columns in the Figure. Third, there may be also more different degrees of error protection in one or two other dimensions of the array. Further, the block shown as user data in Figure 1 may have additional internal error protection not shown for brevity, or the arrangement according to Figure 1 may be a subordinate layer in a higher order error protection organization.

Figure 2 is a block diagram of an encoding and/or decoding device according to the invention. In its most complicated form it may execute both encoding and decoding. In most practical cases, it would be able to execute only one of the two. Although in that case the internal constitution of encoder and decoder could be quite different, for reasons of brevity the set-up has been shown identically, which is not to be construed as a limitation. Now, first, its use as an encoding apparatus is described. The user elements arrive on input 20, accompanied with some kind of bit, symbol and block synchronization. Input unit 22 receives the elements and converts them, if necessary, for storage in input store 24. For this object, general control device 30 assigns the necessary store addresses. The development of the column parity symbols may proceed on the fly by first encoder device 26, in that the contribution of each user element to the parity symbols of its column is directly accumulated. Input unit 22 signals to general control device 30 when one of the columns of user elements has been completely received, and in consequence, when the associated P-symbols are ready. If all columns have been processed, transition element 28 is activated so that second encoder device 32 may likewise produce the row parity symbols along with storage in the output store 34. When all elements, to wit, user elements and column redundant elements, have been processed, also all row redundant elements have been produced, output element 36 is activated, so that the encoded block may appear at output 38. If required, the encoding devices and stores may be shared, as long as general control device 30 keeps correctly track of all addresses and operations. The operations as shown may occur along with interleaving or deinterleaving on either the input 20 or the output 38. In another realization, not show explicitly, both row and column parities are generated on-the-fly, together with the reception of the user elements.

Next, the use of the device according to Figure 2 as a decoding apparatus is described. The encoded block of elements arrives on input 20, accompanied with some bit, symbol and block synchronization. Input unit 22 receives the elements and converts them, if necessary, for storage in input store 24. Such conversion does not influence the information content of the elements although it may change their representation. For correct storage, general control device 30 assigns the necessary store addresses. The development of the row syndrome symbols may proceed on the fly by first decoder device 26, in that the contribution of each user element to the syndrome of its column is directly accumulated. Input unit 22 signals to general control device 30 when one of the rows of user elements has been completely received, and in consequence, when the decoding of the word in question may proceed. The result may be either "no error", or "error corrected", or "error present, but not corrected", taking into account the adopted strategy for error correction. Each of the latter two cases may imply putting flags on all or particular ones of the symbols of the word in question, as has been disclosed in the art, but which is not described here for reasons of brevity. If all rows have been processed, decoder device 26 at its output produces an enabling signal to general control device 30, so that it may activate transition element 28 for transferring the symbols present in input store 24 to output store 34 column-by-column so that second decoder device 32 may now likewise produce the column syndrome symbols along with the storage in the output store 34. Another solution is that the column syndromes are generated together with the row syndromes at the input side. This would then require updating of the column syndromes together with any occurring correction store 34. When all elements of a column have been processed, the syndrome symbols, and as the case may be, any flag produced in the first stage, are used for decoding the column in question. As before, the result may be "no error", or "error corrected", or "error present, but not corrected". In the latter case it has been known in the art to activate the row decoding once more, but this refinement is foregone for reasons of brevity. When the whole block has accordingly been decoded, output element 36 is activated, so that the decoded block may appear at output 38. If required, the encoding devices and stores may be shared, as long as general control device 30 keeps correctly track of all addresses and operations. The operations as shown may occur along with interleaving or deinterleaving on either the input 20 or the output 38.

## Claims

1. A method for encoding digital data with at least two different degrees of error protection, said method comprising distributing uniform-size user elements of said data over an array of at least two dimensions, supplementing according to at least one of said dimensions said user elements with first redundant elements of said uniform size of a first linear coding, and supplementing according to at least a second one of said dimensions said user elements and first redundant elements with second redundant elements of said uniform size of a second linear coding, wherein said first linear coding for at least one first line of user elements realizes a higher degree of error protection than for at least one second line of user elements in that the former is realized as a first code that has more of said first redundant elements than the latter that is realized as a second code.

2. A method as claimed in Claim 1, wherein all code words of said first coding have a first uniform size and all code words of said second coding have a second uniform size.

3. A method as claimed in Claim 1 or 2, wherein said higher degree of error protection is realized through a greater minimum distance.

4. A method as claimed in Claim 1, 2 or 3, wherein said first linear coding is also arranged to protect said second redundant elements.

5. A method as claimed in any of Claims 1 to 4, wherein said first code is a subcode of said second code.

6. An apparatus for encoding digital data with at least two different degrees of error protection, said method comprising distributing means for distributing uniform-size user elements of said data over an array of at least two dimensions, first encoding means for supplementing according to at least one of said dimensions said user elements with first redundant elements of said uniform size of a first linear coding, and second encoding means fed by said first encoding means for supplementing according to at least a second one of said dimensions said user elements and first redundant elements with second redundant elements of said uniform size of a second linear coding, wherein said first encoding means for at least one first line of user elements realize a higher degree of error protection than for at least one second line of user elements in that the former is realized as a first code that has more of said first redundant elements than the latter that is realized as a second code.

7. A method for decoding digital data with at least two different degrees of error protection, which digital data have uniform-size user elements distributed over an array of at least two dimensions, supplemented according to at least one of said dimensions with first redundant elements of said uniform size of a first linear coding, and supplemented according to at least a second one of said dimensions with second redundant elements of said uniform size of a second linear coding, said first coding realizing for at least one first line of user elements a higher degree of error protection than for at least one second line of user elements in that for the former a higher number of said first redundant elements of a first code is taken into account than those being present for the latter that represent a second code.

8. A method as claimed in Claim 7, wherein all code words of said second coding relating to said array are decoded first before enabling decoding of any code word of said first coding relating to said array.

9. An apparatus for decoding digital data with at least two different degrees of error protection, which digital data have uniform-size user elements distributed over an array of at least two dimensions, supplemented according to at least one of said dimensions with first redundant elements of said uniform size of a first linear coding, and supplemented according to at least a second one of said dimensions with second redundant elements of said uniform size of a second linear coding, first decoding means for within said first coding realizing for at least one first line of user elements a higher degree of error protection than for at least one second line of user elements by taking into account for the former a higher number of said first redundant elements of a first code than those being present for the latter that represent a second code.

10. An apparatus as claimed in Claim 9, and having second decoding means for decoding code words of said second coding, enabling means fed by said second decoding means for generating an enabling signal upon completing decoding of all code words of said second coding relating to a particular said array, said first decoding means being fed by said enabling means for conditional to reception of said enabling signal undertaking decoding of any code word of said first coding relating to the latter array.

## Patentansprüche

1. Verfahren zur Codierung digitaler Daten mit mindestens zwei verschiedenen Fehlerschutzstufen, wobei das genannte Verfahren folgendes umfaßt: das Verteilen von gleichgroßen Benutzerelementen der genannten Daten auf eine mindestens zweidimensionale Gruppierung; das Ergänzen der genannten Benutzerelemente entsprechend mindestens einer der genannten Dimensionen durch erste redundante Elemente der genannten gleichförmigen Größe von einer ersten linearen Codierung; und das Ergänzen der genannten Benutzerelemente und der ersten redundanten Elemente entsprechend mindestens einer zweiten der genannten Dimensionen durch zweite redundante Elemente der genannten gleichförmigen Größe von einer zweiten linearen Codierung, wobei die genannte erste lineare Codierung für mindestens eine erste Zeile von Benutzerelementen eine höhere Fehlerschutzstufe realisiert als für mindestens eine zweite Zeile von Benutzerelementen, und zwar dadurch, daß die erstere als ein erster Code realisiert wird, der mehr der genannten ersten redundanten Elemente enthält als die letztere, die als ein zweiter Code realisiert wird.

2. Verfahren nach Anspruch 1, wobei alle Codeworte der genannten ersten Codierung eine erste gleichförmige Größe haben und alle Codeworte der genannten zweiten Codierung eine zweite gleichförmige Größe haben.

3. Verfahren nach Anspruch 1 oder 2, wobei die genannte höhere Fehlerschutzstufe durch einen größeren Mindestabstand realisiert wird.

4. Verfahren nach Anspruch 1, 2 oder 3, wobei die genannte erste lineare Codierung auch vorgesehen ist, um genannte zweite redundante Elemente zu schützen.

5. Verfahren nach einem der Ansprüche 1 bis 4, wobei der genannte erste Code ein Subcode des genannten zweiten Codes ist.

6. Vorrichtung zum Codieren digitaler Daten mit mindestens zwei verschiedenen Fehlerschutzstufen, wobei das genannte Verfahren folgendes umfaßt: Verteilungsmittel zum Verteilen von gleichgroßen Benutzerelementen der genannten Daten auf eine mindestens zweidimensionale Gruppierung; erste Codiermittel zum Ergänzen der genannten Benutzerelemente entsprechend mindestens einer der genannten Dimensionen durch erste redundante Elemente der genannten gleichförmigen Größe von einer ersten linearen Codierung; und zweite Codiermittel, die durch die ersten Codiermittel versorgt werden, zum Ergänzen der genannten Benutzerelemente und der ersten redundanten Elemente entsprechend mindestens einer zweiten der genannten Dimensionen durch zweite redundante Elemente der genannten gleichförmigen Größe von einer zweiten linearen Codierung, wobei die genannten ersten Codiermittel für mindestens eine erste Zeile von Benutzerelementen eine höhere Fehlerschutzstufe realisieren als für mindestens eine zweite Zeile von Benutzerelementen, und zwar dadurch, daß die erstere als ein erster Code realisiert wird, der mehr der genannten ersten redundanten Elemente enthält als die letztere, die als ein zweiter Code realisiert wird.

7. Verfahren zum Decodieren digitaler Daten mit mindestens zwei verschiedenen Fehlerschutzstufen, wobei die digitalen Daten Benutzerelemente gleichförmiger Größe haben, die über eine mindestens zweidimensionale Gruppierung verteilt sind und die entsprechend mindestens einer der genannten Dimensionen durch erste redundante Elemente der genannten gleichförmigen Größe von einer ersten linearen Codierung ergänzt werden und die entsprechend mindestens einer zweiten der genannten Dimensionen durch zweite redundante Elemente der genannten gleichförmigen Größe von einer zweiten linearen Codierung ergänzt werden, wobei die genannte erste Codierung für mindestens eine erste Zeile von Benutzerelementen eine höhere Fehlerschutzstufe realisiert als für mindestens eine zweite Zeile von Benutzerelementen, und zwar dadurch, daß für die erstere eine größere Anzahl der genannten ersten redundanten Elemente eines ersten Codes berücksichtigt wird als für die letztere vorhanden sind, die einen zweiten Code darstellt.

8. Verfahren nach Anspruch 7, wobei alle Codeworte der genannten zweiten Codierung, die sich auf die genannte Gruppierung beziehen, zuerst decodiert werden, bevor die Decodierung eines Codewortes der genannten ersten Codierung aktiviert wird, das sich auf die genannte Gruppierung bezieht.

9. Vorrichtung zum Decodieren digitaler Daten mit mindestens zwei verschiedenen Fehlerschutzstufen, wobei die digitalen Daten Benutzerelemente gleichförmiger Größe haben, die über eine mindestens zweidimensionale Gruppierung verteilt sind und die entsprechend mindestens einer der genannten Dimensionen durch erste redundante Elemente der genannten gleichförmigen Größe von einer ersten linearen Codierung ergänzt werden und die entsprechend mindestens einer zweiten der genannten Dimensionen durch zweite redundante Elemente der genannten gleichförmigen Größe von einer zweiten linearen Codierung ergänzt werden; mit ersten Decodiermitteln, mit denen innerhalb der genannten ersten Codierung für mindestens eine erste Zeile von Benutzerelementen eine höhere Fehlerschutzstufe realisiert wird als für mindestens eine zweite Zeile von Benutzerelementen, indem für die erstere eine größere Anzahl der genannten ersten redundanten Elemente eines ersten Codes berücksichtigt wird als für die letztere vorhanden sind, die einen zweiten Code darstellt.

10. Vorrichtung nach Anspruch 9 und mit zweiten Decodiermitteln zum Decodieren von Codeworten der genannten zweiten Codierung, Aktiviermitteln, die durch die genannten zweiten Decodiermittel versorgt werden, um auf die Beendigung der Decodierung aller Codeworte der genannten zweiten Codierung hin, die sich auf eine bestimmte genannte Gruppierung beziehen, ein Aktiviersignal zu erzeugen, wobei die ersten Decodiermittel durch die genannten Aktiviermittel versorgt werden, um bei Empfang des genannten Aktiviersignals die Decodierung eines Codewortes der ersten genannten Codierung vorzunehmen, das sich auf die letztgenannte Gruppierung bezieht.

## Revendications

1. Procédé pour coder des données numériques avec au moins deux degrés différents de protection contre les erreurs, ledit procédé comprenant les étapes visant à répartir des éléments utilisateur de taille uniforme desdites données sur une matrice au moins bidimensionnelle, à compléter, conformément à au moins une desdites dimensions, lesdits éléments utilisateur avec des premiers éléments redondants de ladite taille uniforme d'un premier codage linéaire, et à compléter, conformément à au moins une deuxième desdites dimensions, lesdits éléments utilisateur et les premiers éléments redondants avec des deuxièmes éléments redondants de ladite taille uniforme d'un deuxième codage linéaire, dans lequel ledit premier codage linéaire pour au moins une première ligne d'éléments utilisateur réalise un degré de protection contre les erreurs plus élevé que pour au moins une deuxième ligne d'éléments utilisateur, du fait que la première est réalisée sous la forme d'un premier code qui comprend plus d'éléments desdits premiers éléments redondants que la dernière qui est réalisée sous la forme d'un deuxième code.

2. Procédé suivant la revendication 1, dans lequel tous les mots de code dudit premier codage ont une première taille uniforme et tous les mots de code dudit deuxième codage ont une deuxième taille uniforme.

3. Procédé suivant la revendication 1 ou 2, dans lequel ledit degré supérieur de protection contre les erreurs est réalisé par une plus grande distance minimum.

4. Procédé suivant la revendication 1, 2 ou 3, dans lequel ledit premier code est un sous-code dudit deuxième code.

5. Procédé suivant l'une quelconque des revendications 1 à 4, dans lequel ledit premier code est un sous-code dudit deuxième code.

6. Appareil pour coder des données numériques avec au moins deux degrés différents de protection contre les erreurs, ledit appareil comprenant des moyens de répartition pour répartir des éléments utilisateur de taille uniforme desdites données sur une matrice au moins bidimensionnelle, des premiers moyens de codage pour compléter, conformément à au moins une desdites dimensions, lesdits éléments utilisateur avec des premiers éléments redondants de ladite taille uniforme d'un premier codage linéaire, et des deuxièmes moyens de codage alimentés par lesdits premiers moyens de codage pour compléter, conformément à au moins une deuxième desdites dimensions, lesdits éléments utilisateur et premiers éléments redondants avec des deuxièmes éléments redondants de ladite taille uniforme d'un deuxième codage linéaire, dans lequel lesdits premiers moyens de codage pour au moins une première ligne d'éléments utilisateur réalisent un degré de protection contre les erreurs plus élevé que pour au moins une deuxième ligne d'éléments utilisateur du fait que la première est réalisée sous la forme d'un premier code qui comprend plus d'éléments desdits premiers éléments redondants que la dernière qui est réalisée sous la forme d'un deuxième code.

7. Procédé pour décoder des données numériques avec au moins deux degrés de protection contre les erreurs différents, lesquelles données numériques comprennent des éléments utilisateur de taille uniforme répartis sur une matrice au moins bidimensionnelle, complétés conformément à au moins une desdites dimensions, avec des premiers éléments redondants de ladite taille uniforme d'un premier codage linéaire, et complétés, conformément à au moins une deuxième desdites dimensions, avec des deuxièmes éléments redondants de ladite taille uniforme d'un deuxième codage linéaire, ledit premier codage réalisant pour au moins une première ligne d'éléments utilisateur un degré de protection contre les erreurs plus élevé que pour au moins une deuxième ligne d'éléments utilisateur du fait que pour la première, on prend en compte un nombre desdits premiers éléments redondants d'un premier code plus grand que le nombre des éléments redondants présents pour la dernière représentant un deuxième code.

8. Procédé suivant la revendication 7, dans lequel tous les mots de code dudit deuxième codage se rapportant à ladite matrice sont tout d'abord décodés avant de valider le décodage de tout mot de code dudit premier code se rapportant à ladite matrice.

9. Appareil pour décoder des données numériques avec au moins deux degrés de protection contre les erreurs différents, lesquelles données numériques comprennent des éléments utilisateur de taille uniforme répartis sur une matrice au moins bidimensionnelle, complétés conformément à au moins une desdites dimensions, avec des premiers éléments redondants de ladite taille uniforme d'un premier codage linéaire, et complétés, conformément à au moins une deuxième desdites dimensions, avec des deuxièmes éléments redondants de ladite taille uniforme d'un deuxième codage linéaire, des premiers moyens de décodage étant prévus pour réaliser, dans ledit premier codage, pour au moins une première ligne d'éléments utilisateur, un degré de protection contre les erreurs plus élevé que pour au moins une deuxième ligne d'éléments utilisateur en prenant en compte pour la première un nombre desdits premiers éléments redondants d'un premier code plus grand que le nombre de ces éléments présents pour la dernière représentant un deuxième code.

10. Appareil suivant la revendication 9, et comprenant des deuxièmes moyens de décodage pour décoder des mots de code dudit deuxième codage, des moyens de validation alimentés par lesdits deuxièmes moyens de décodage pour générer un signal de validation à l'achèvement du décodage de tous les mots de code dudit deuxième codage concernant une dite matrice particulière, lesdits premiers moyens de décodage étant alimentés par lesdits moyens de validation pour entreprendre, sous certaines conditions, à la réception dudit signal de validation, le décodage de tout mot de code dudit premier codage concernant la dernière matrice.
